# EUROPEAN PATENT APPLICATION

(11) **EP 3 291 295 A1**
(43) Date of publication of application: **07.03.2018**
(21) Application number: 17179498.5
(22) Date of filing: 04.07.2017
(51) Int. Cl.: H01L 23/498, H01L 21/60, H01L 23/31, H01L 23/485

(54) **PRE-BUMPED REDISTRIBUTION LAYER STRUCTURE AND SEMICONDUCTOR PACKAGE INCORPORATING SUCH PRE-BUMPED REDISTRIBUTION LAYER STRUCTURE**

(30) Priority: 19.08.2016 US 201662376931 P; 14.06.2017 US 201715623361
(71) Applicant: MediaTek Inc., Hsin-Chu 300 (TW)
(72) Inventor: KUO, Che-Hung, Tainan City 704 (TW); CHOU, Che-Ya, Kaohsiung City 806 (TW); CHEN, Nan-Cheng, Hsinchu City 300 (TW)
(74) Representative: Hoefer & Partner Patentanwälte mbB

(57) **Abstract**

A pre-bumped redistribution layer (RDL) structure is disclosed. The pre-bumped RDL structure includes at least a dielectric layer, a first metal layer on the first surface, a second metal layer on the second surface, and a via layer electrically connecting the first metal layer and the second metal layer. At least a bump pad is formed in the first metal layer. A bump is disposed on the bump pad. The bump comprises a copper layer with its lower end directly jointed to a top surface of the bump pad.

## Description

### Background

The present invention relates generally to semiconductor packaging and, more particularly, to a semiconductor package incorporating a pre-bumped redistribution layer (RDL) structure.

As known in the art, there are a variety of chip package techniques such as ball grid array (BGA), wire bonding, flip-chip, etc. for mounting a semiconductor die (or chip) on a substrate via the bonding points on both the semiconductor die and the substrate. To ensure miniaturization and multi-functionality of electronic products or communication devices, semiconductor packages are required to be of small in size, multi-pin connection, high speed, and high functionality.

For example, fan-out wafer level packaging (FOWLP) is an embedded type packaging method during wafer level processing and is also a major advanced packaging technology for packaging a large quantity of inputs and outputs (I/O) with high integration flexibility.

In a "chip-last" packaging process, bumped semiconductor dice may be mounted on a package substrate using flip-chip bonding. The package substrate may be an interposer that includes metal connections for routing electrical signals between opposite sides. The semiconductor dice may be bonded to the substrate through solder bonding. After the die bonding, the semiconductor dice and package substrate are overmolded with a molding compound.

The "chip-last" packaging process may prevent yield loss of known-good-dies. However, the production cost of the multi-chip package is increased as the number the semiconductor dice in one single package increases because each die in the package needs a separate bumping process, bump mapping, and individual photomask for defining the bump pad openings on each die before die bonding.

### Summary

This in mind, the present invention aims at providing an improved semiconductor package incorporating a pre-bumped redistribution layer (RDL) structure.

This is achieved by a semiconductor package according to the pre-characterizing clause of claim 1. The dependent claims pertain to corresponding further developments and improvements.

As will be seen more clearly from the detailed description following below, the semiconductor package includes a pre-bumped redistribution layer (RDL) structure having opposite first and second surfaces. The pre-bumped RDL structure includes at least a bump pad on the first surface and a bump on the bump pad. A semiconductor die is mounted on the first surface of the pre-bumped RDL structure. The semiconductor die is a flip-chip with its active surface facing toward the pre-bumped RDL structure. A plurality of input/output (I/O) pads is disposed on the active surface of the semiconductor die. Each of the plurality of I/O pads is connected to the bump of the pre-bumped RDL structure. A molding compound encapsulates the semiconductor die and covers the first surface of the pre-bumped RDL structure. A plurality of conductive bumps is mounted on the second surface of the pre-bumped RDL structure.

According to another aspect of the invention, a pre-bumped redistribution layer (RDL) structure is disclosed. The pre-bumped RDL structure includes at least a dielectric layer, a first metal layer on the first surface, a second metal layer on the second surface, and a via layer electrically connecting the first metal layer and the second metal layer. At least a bump pad is formed in the first metal layer. A bump is disposed on the bump pad. The bump comprises a copper layer with its lower end directly jointed to a top surface of the bump pad.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the embodiments, and are incorporated in and constitute a part of this specification. The drawings illustrate some of the embodiments and, together with the description, serve to explain their principles. In the drawings:
FIG. 1 to FIG. 4 illustrate an exemplary method for fabricating a semiconductor package incorporating a pre-bumped redistribution layer (RDL) structure according to one embodiment of the invention; and
FIGS. 5-7 are schematic, enlarged partial views showing various bonding structures between the semiconductor die and the pre-bumped RDL structure according to embodiments of the invention.

### Detailed Description

In the following detailed description of the disclosure, reference is made to the accompanying drawings, which form a part hereof, and in which is shown, by way of illustration, specific embodiments in which the invention may be practiced. These embodiments are described in sufficient detail to enable those skilled in the art to practice the invention. Other embodiments may be utilized and structural changes may be made without departing from the scope of the present disclosure.

The following detailed description is, therefore, not to be taken in a limiting sense, and the scope of the present invention is defined only by the appended claims, along with the full scope of equivalents to which such claims are entitled.

One or more implementations of the present invention will now be described with reference to the attached drawings, wherein like reference numerals are used to refer to like elements throughout, and wherein the illustrated structures are not necessarily drawn to scale.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The term "horizontal" as used herein is defined as a plane parallel to a major plane or surface of the substrate, regardless of its orientation. The term "vertical" refers to a direction perpendicular to the horizontal as just defined. Terms, such as "on", "above", "below", "bottom", "top", "side" (as in "sidewall"), "higher", "lower", "over", and "under", are defined with respect to the horizontal plane.

The present invention pertains to a pre-bumped redistribution layer (RDL) structure and a semiconductor package incorporating such pre-bumped RDL structure. The semiconductor package may be a single-die package or a multi-die package.

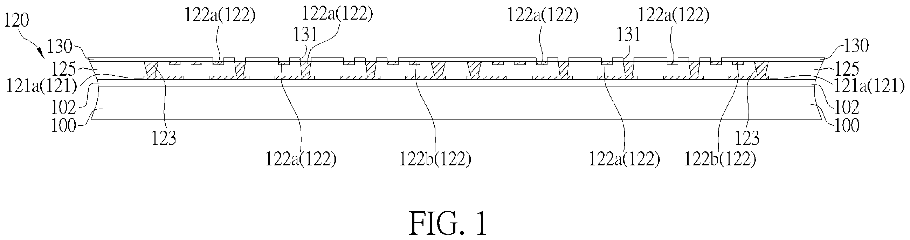

FIG. 1 to FIG. 4 illustrate an exemplary method for fabricating a semiconductor package incorporating a pre-bumped redistribution layer (RDL) structure according to one embodiment of the invention.

As shown in FIG. 1, a carrier substrate 100 is provided. According to one embodiment, the carrier substrate 100 may comprise glass, silicon, ceramic, or metal, but is not limited thereto. According to one embodiment, a release layer 102 may be formed on a top surface of the carrier substrate 100.

A redistribution layer (RDL) structure 120 is then formed on the release layer 102. The RDL structure 120 may comprise at least a dielectric layer 125, a metal layer 121, a metal layer 122, and a via layer 123 electrically connecting the metal layer 121 and the metal layer 122.

According to one embodiment, for example, the metal layer 121 may comprise conductive bump pads 121a and metal traces not explicitly shown in this figure, and the metal layer 122 may comprise bump pads 122a and metal traces 122b. It is understood that the layers and patterns in the RDL structure 120 as depicted in the figures are for illustration purposes only. The number of the metal layers in the RDL structure 120 may depend upon the design requirements.

According to one embodiment, the metal layers 121 and 122, and the via layer 123 may comprise aluminum, copper, tungsten, titanium, titanium nitride, or the like. The dielectric layer 125 may comprise any suitable insulating materials including, but not limited to, photo image dielectric (PID) materials, prepreg, resin materials such as Ajinomoto Build-up Film (ABF) or the like.

According to one embodiment, the metal patterns in the dielectric layer 125 may be formed by build-up processes and plating processes, but is not limited thereto. In another embodiment, the dielectric layer 125 may comprise inorganic materials such as silicon oxide, silicon nitride or the like, and the metal patterns in the dielectric layer 125 may be formed by photolithographic processes and etching processes.

According to one embodiment, the metal traces or metal patterns formed in the dielectric layer 125 may have a line width ranging between 1∼10 micrometers and a space (between two adjacent lines) ranging between 1∼10 micrometers, but is not limited thereto.

According to one embodiment, optionally, a mask 130 such as a dielectric layer or a solder mask may be formed on the dielectric layer 125 and the metal layer 122. The mask 130 may comprise a plurality of openings 131 that expose the bump pads 122a of the metal layer 122, respectively.

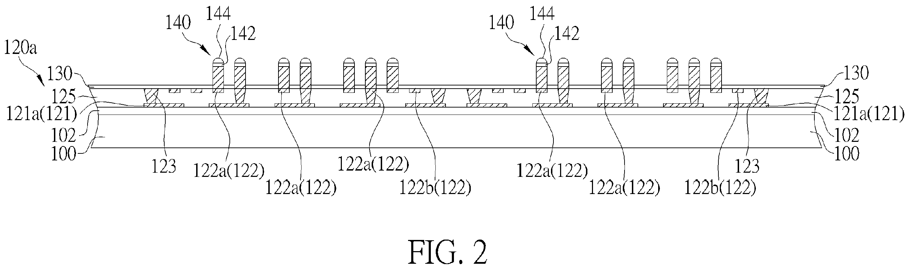

As shown in FIG. 2, subsequently, bumps 140 are formed on the bump pads 122a, respectively, thereby forming a pre-bumped RDL structure 120a. According to one embodiment, the bumps 140 may comprise metals such tin, copper, silver, or gold, but is not limited thereto. According to one embodiment, the bumps 140 are copper pillars.

To form the bumps 140 on the bump pads 122a, for example, a seed layer (not shown) such as a copper seed layer may be formed on the bump pads 122a, and then a resist layer (not shown) for defining the pattern and location of the bumps 140 may be formed on the seed layer. Thereafter, a plating process may be performed to form the bumps 140 such as copper pillar bumps. The resist layer is then removed. The seed layer not covered by the bumps 140 is also removed.

Optionally, the bump 140 may further comprise an intermediate metal layer 142. For example, the intermediate metal layer 142 may comprise nickel or a nickel-containing layer, but is not limited thereto. Optionally, the bump 140 may further comprise a solder layer 144 provided directly on the intermediate metal layer 142. The solder layer 144 may be a lead-free pre-solder layer formed of, for example, SnAg, or a solder material, including alloys of tin, lead, silver, copper, nickel, bismuth, or combinations thereof.

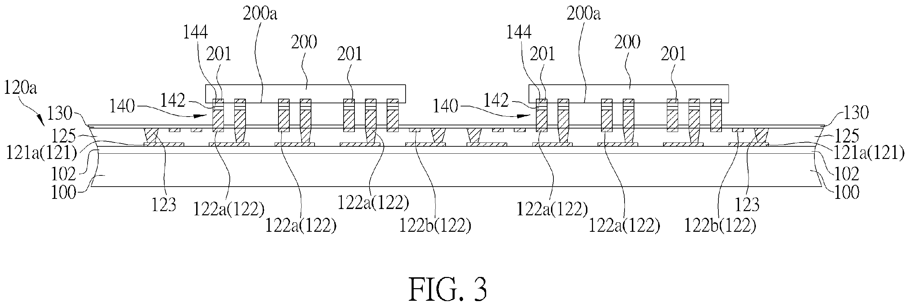

As shown in FIG. 3, a semiconductor die 200 is mounted within each chip mounting area on the pre-bumped RDL structure 120a. According to one embodiment, the semiconductor die 200 is a flip-chip with its active surface 200a facing down toward the pre-bumped RDL structure 120a. A plurality of input/output (I/O) pads 201 may be disposed on the active surface 200a of the semiconductor die 200.

According to another embodiment, the semiconductor package may be a multi-die package. For example, two or more than two semiconductor dice 200 are mounted within chip mounting areas, respectively, on the pre-bumped RDL structure 120a, and each of the semiconductor dice 200 is a flip-chip with its active surface 200a facing down toward the pre-bumped RDL structure 120a. A plurality of input/output (I/O) pads 201 may be disposed on the active surface 200a of each of the semiconductor dice 200.

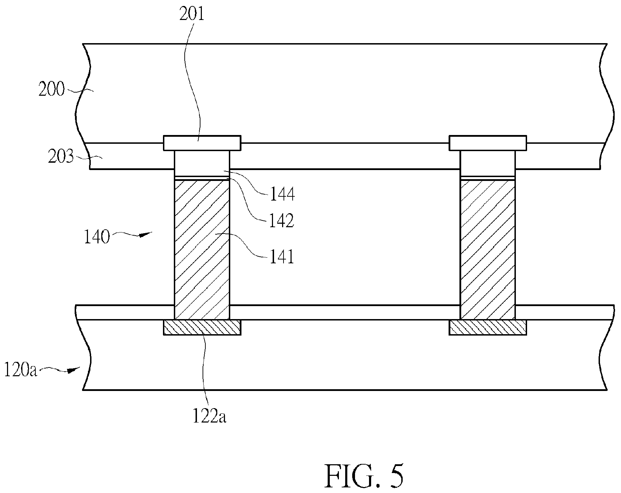

Please also refer briefly to FIGS. 5-7. FIGS. 5-7 are schematic, enlarged partial views showing various bonding structures between the semiconductor die 200 and the pre-bumped RDL structure 120a according to various embodiments of the invention.

As shown in FIG. 5, according to one embodiment, each of the I/O pads 201 of the semiconductor die 200 has a top surface, which may be an aluminum (or copper) surface of the I/O pad itself, exposed from a passivation layer 203. In other words, no additional connecting element such as a metal bump or a metal pillar is disposed on the top surface of each of the I/O pads 201 before die bonding. The top surface of each of the I/O pads 201 is directly coupled to a corresponding bump 140 through, for example, the solder layer 144. Optionally, according to another embodiment, a surface finish layer (not explicitly shown) such as organic solderability preservatives (OSP) may be provided on exposed top surface of each of the I/O pads 201.

In FIG. 5, according to one embodiment, the bump 140 comprises a copper layer 141 with its lower end (or bottom surface) directly jointed to a top surface of the bump pad 122a. That is, no solder or pre-solder is disposed between the copper layer 141 of the bump 140 and the bump pad 122a. FIG. 5 shows that the bonding structure has the solder layer 144 that is disposed only between the copper layer 141 and the I/O pad 201. The solder layer 144 is situated closer to the semiconductor die 200 than the copper layer 141 of the bump 140. Further, a cross-sectional area of the solder layer 144 is equal to that of the copper layer 141.

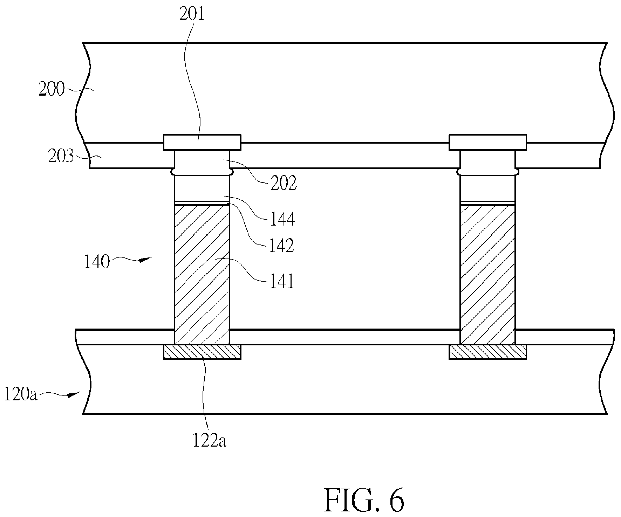

As shown in FIG. 6, each of the I/O pads 201 of the semiconductor die 200 has a top surface, which may be an aluminum (or copper) surface of the I/O pad itself. According to this embodiment, an under bump metal (UBM) layer 202 is formed on the top surface of each of the I/O pads 201. However, no metal bump (e.g. copper bump) or metal pillar (e.g. copper pillar) is disposed on the UBM layer 202. Each of the I/O pads 201 of the semiconductor die 200 is coupled to a corresponding bump 140 through, for example, the UBM layer 202 pre-fabricated on the I/O pad 201 and the solder layer 144 of the bump 140. The solder layer 144 is situated closer to the semiconductor die 200 than the copper layer 141 of the bump 140. Further, a cross-sectional area of the solder layer 144 is equal to that of the copper layer 141.

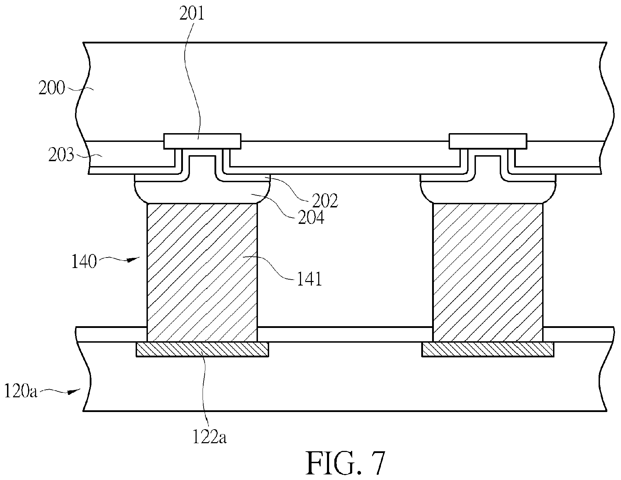

As shown in FIG. 7, each of the I/O pads 201 of the semiconductor die 200 has a top surface, which may be an aluminum (or copper) surface of the I/O pad itself. According to this embodiment, an under bump metal (UBM) layer 202 is formed on the top surface of each of the I/O pads 201. A pre-solder layer 204 is formed on the UBM layer 202. Each of the I/O pads 201 of the semiconductor die 200 is coupled to a corresponding bump 140 through, for example, the UBM layer 202 and the pre-solder layer 204 pre-fabricated on the I/O pad 201. In a case as depicted in FIG. 7, it is understood that the intermediate metal layer 142 and the solder layer 144 may be omitted. According to this embodiment, the solder layer 144 is situated closer to the semiconductor die 200 than the copper layer 141 of the bump 140. Further, a cross-sectional area of the solder layer 144 is greater to that of the copper layer 141.

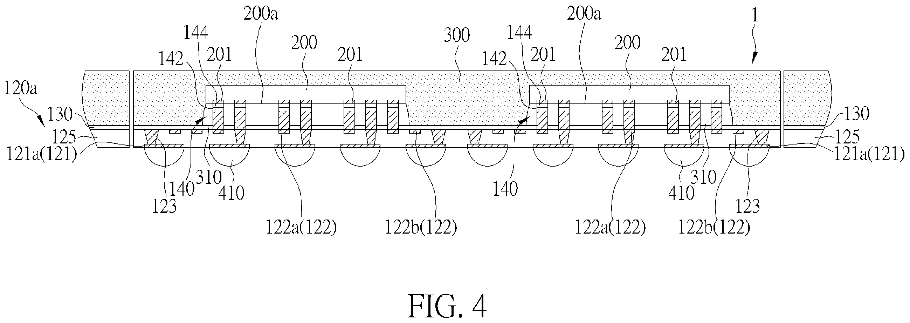

As shown in FIG. 4, after mounting the semiconductor dice 200 on the pre-bumped RDL structure 120a, a molding compound 300 is applied. The molding compound 300 at least covers the semiconductor dice 200 and the top surface of the pre-bumped RDL structure 120a. According to one embodiment, the molding compound 300 may be subjected to a curing process. The molding compound 300 may comprise a mixture of epoxy and silica fillers, but not limited thereto.

According to another embodiment, prior to the formation of the molding compound 300, an underfill 310 may be applied between each of the semiconductor dice 200 and the pre-bumped RDL structure 120a. The underfill 310 may be a silica filled epoxy, but is not limited thereto. The underfill 310 fills the gap (or standoff) between each of the semiconductor dice 200 and the pre-bumped RDL structure 120a.

Subsequently, the carrier substrate 100 and the release layer 102 are removed to thereby expose a lower surface of the pre-bumped RDL structure 120a. The de-bonding of the carrier substrate 100 may be performed by using heating, laser, UV/IR irradiation, or mechanical peeling, but not limited thereto. After the carrier substrate 100 is removed, a lower surface of each of the conductive bump pads 121a of the metal layer 121 is revealed.

According to one embodiment, no metal finish is formed on the exposed lower surface of each of the conductive bump pads 121a of the metal layer 121. The thickness of the metal layer 121 may range between 1 and 20 micrometers. According to another embodiment, a metal finish such as Ni, Au, and/or other elemental metals may be formed on the exposed lower surface of each of the conductive bump pads 121 a of the metal layer 121.

Subsequently, conductive bumps 410 are disposed on respective conductive bump pads 121a of the metal layer 121 to complete a wafer level package. The wafer level package is then subjected to a wafer dicing process and singulated into semiconductor packages 1.

It is advantageous to use the invention because the bumps 140 are pre-fabricated on the RDL structure 120 (pre-bumped RDL structure 120a). Therefore, masks for individual bumping on each die may be spared and the production cost is reduced. In addition, bumps on the I/O pads on each of the die can be omitted, thereby saving the process time of the semiconductor packages.

## Claims

1. A semiconductor package (1), comprising:
a pre-bumped redistribution layer (RDL) structure (120a) having opposite first and second surfaces, wherein the pre-bumped RDL structure (120a) comprises at least a bump pad (122a) on the first surface and a bump (140) on the bump pad (122a);
a semiconductor die (200) mounted on the first surface of the pre-bumped RDL structure (120a), wherein the semiconductor die (200) is a flip-chip with its active surface (200a) facing toward the pre-bumped RDL structure (120a), wherein a plurality of input/output (I/O) pads (201) is disposed on the active surface (200a) of the semiconductor die (200), and wherein each of the plurality of I/O pads (201) is connected to the bump (140) of the pre-bumped RDL structure (120a); and
a plurality of conductive bumps (410) mounted on the second surface of the pre-bumped RDL structure (120a).

2. The semiconductor package (1) according to claim 1, **characterised in that** the pre-bumped RDL structure (120a) comprises at least a dielectric layer (125), a first metal layer (122) on the first surface, a second metal layer (121) on the second surface, and a via layer (123) electrically connecting the first metal layer (122) and the second metal layer (121), wherein the bump pad (122a) is in the first metal layer (122).

3. The semiconductor package (1) according to claim 1, **characterised in that** the bump (140) comprises an intermediate metal layer (142) and a solder layer (144) directly on the intermediate metal layer (142).

4. The semiconductor package (1) according to claim 3, **characterised in that** the bump (140) comprises a copper layer (141; FIG. 5) with its lower end directly jointed to a top surface of the bump pad (122a), wherein the intermediate metal layer (142) is disposed directly on the copper layer (141; FIG. 5).

5. The semiconductor package (1) according to claim 4, **characterised in that** the solder layer (144) is situated closer to the semiconductor die (200) than the copper layer (141) of the bump (140).

6. The semiconductor package (1) according to claim 3, **characterised in that** each I/O pad (201) has a top surface, which is an aluminum or copper surface of said each I/O pad itself, wherein no metal bump or metal pillar is disposed on the top surface of said each I/O pad (201) before die bonding, and wherein the top surface of said each I/O pad (201) is jointed to the bump (140) of the pre-bumped RDL structure (120a) through the solder layer (144).

7. The semiconductor package (1) according to claim 6, **characterised in that** the semiconductor package (1) further comprises a surface finish layer on the top surface of said each I/O pad (201).

8. The semiconductor package (1) according to claim 7, **characterised in that** the surface finish layer comprises an organic solderability preservative (OSP).

9. The semiconductor package (1) according to claim 7, **characterised in that** the semiconductor package (1) further comprises an under bump metal (UBM) layer (202; FIG. 6, FIG. 7) on the top surface of said each I/O pad (201).

10. The semiconductor package (1) according to claim 1, **characterised in that** the semiconductor package (1) further comprises a molding compound (300) encapsulating the semiconductor die (200) and covering the first surface of the pre-bumped RDL structure (120a).

11. The semiconductor package (1) according to claim 4, **characterised in that** a cross-sectional area of the solder layer (144; FIG. 5) is equal to that of the copper layer (141).

12. The semiconductor package (1) according to claim 4, **characterised in that** a cross-sectional area of the solder layer (204; FIG. 7) is greater to that of the copper layer (141).

13. A pre-bumped redistribution layer (RDL) structure (120a), comprising:
at least a dielectric layer (125), a first metal layer (122) on the first surface, a second metal layer (121) on the second surface, and a via layer (123) electrically connecting the first metal layer (122) and the second metal layer (121); and
at least a bump pad (122a) in the first metal layer (122); and
a bump (140) on the bump pad (122a).

14. The pre-bumped RDL structure (120a) according to claim 13, **characterised in that** the bump (140) comprises an intermediate metal layer (142) and a solder layer (144) directly on the intermediate metal layer (142).

15. The pre-bumped RDL structure (120a) according to claim 13, **characterised in that** the bump comprises a copper layer (141, FIG. 5) with its lower end directly jointed to a top surface of the bump pad (122a).

16. A semiconductor package (1), comprising:
a pre-bumped redistribution layer (RDL) structure (120a) having opposite first and second surfaces, wherein the pre-bumped RDL structure (200a) comprises at least a bump pad (122a) on the first surface and a bump (140) on the bump pad (122a);
semiconductor dice (200) mounted on the first surface of the pre-bumped RDL structure (120a), wherein each of the semiconductor dice (200) is a flip-chip with its active surface (200a) facing toward the pre-bumped RDL structure (120a), wherein a plurality of input/output (I/O) pads (201) is disposed on the active surface (200a) of each of the semiconductor dice (200), and wherein each of the plurality of I/O pads (201) is connected to the bump (140) of the pre-bumped RDL structure (120a);
a molding compound (300) encapsulating the semiconductor dice (200) and covering the first surface of the pre-bumped RDL structure (120a); and
a plurality of conductive bumps (410) mounted on the second surface of the pre-bumped RDL structure (120a).

17. The semiconductor package (1) according to claim 16, **characterised in that** the pre-bumped RDL structure (120a) comprises at least a dielectric layer (125), a first metal layer (122) on the first surface, a second metal layer (121) on the second surface, and a via layer (123) electrically connecting the first metal layer (122) and the second metal layer (121), wherein the bump pad (122a) is in the first metal layer (122).

18. The semiconductor package (1) according to claim 16, **characterised in that** the bump (140) comprises an intermediate metal layer (142) and a solder layer (144) directly on the intermediate metal layer (142).

19. The semiconductor package (1) according to claim 18, **characterised in that** the bump (140) comprises a copper layer (141, FIG. 5) with its lower end directly jointed to a top surface of the bump pad (122a), wherein the intermediate metal layer (142) is disposed directly on the copper layer (141, FIG. 5).

20. The semiconductor package (1) according to claim 18, **characterised in that** each I/O pad (201) has a top surface, which is an aluminum or copper surface of said each I/O pad itself, wherein no metal bump or metal pillar is disposed on the top surface of said each I/O pad before die bonding, and wherein the top surface of said each I/O pad (201) is jointed to the bump (140) of the pre-bumped RDL structure (120a) through the solder layer (144).

21. The semiconductor package (1) according to claim 20, **characterised in that** the semiconductor package (1) further comprises a surface finish layer on the top surface of said each I/O pad (201).

22. The semiconductor package (1) according to claim 21, **characterised in that** the surface finish layer comprises organic solderability preservatives (OSP).

23. The semiconductor package (1) according to claim 18, **characterised in that** the semiconductor package (1) further comprises an under bump metal (UBM) layer (202, FIG. 6, FIG.7) on the top surface of said each I/O pad (201).
